Europäisches Patentamt

European Patent Office

Office européen des brevets

(11) Publication number: **0 424 926 A2**

# EUROPEAN PATENT APPLICATION

(21) Application number: 90120433.9

(22) Date of filing: 24.10.90

(51) Int. Cl.5: **H01L 27/06**

(30) Priority: 24.10.89 JP 276896/89

(43) Date of publication of application:
02.05.91 Bulletin 91/18

(84) Designated Contracting States:
**DE FR GB**

(71) Applicant: **KABUSHIKI KAISHA TOSHIBA**
72, Horikawa-cho Saiwai-ku
Kawasaki-shi Kanagawa-ken 210(JP)

Applicant: **TOSHIBA MICRO-ELECTRONICS CORPORATION**
25-1, Ekimae-hon-cho
Kawasaki-ku Kawasaki-shi
Kanagawa-ken(JP)

(72) Inventor: **Yamada, Hideki**
1-29-16, Tamazutsumi
Setagaya-ku, Tokyo-to(JP)

Inventor: **Segawa, Makoto**
2-3-2-206, Minowa-cho, Kohoku-ku
Yokohama-shi, Kanagawa-ken(JP)
Inventor: **Suzuki, Kiminobu**
1185-302, Shin-Yoshida-cho, Kohoku-ku
Yokohama-shi, Kanagawa-ken(JP)
Inventor: **Kobayashi, Kiyoshi**
2-5-8, Naka-Saiwai-cho, Saiwai-ku
Kawasaki-shi, Kanagawa-ken(JP)
Inventor: **Mizukami, Shigeto**
2-7-10, Kirigaoka, Midori-ku
Yokohama-shi, Kanagawa-ken(JP)
Inventor: **Nozawa, Yasumitsu**
1-14-18, Matsumi-cho, Kanagawa-ku
Yokohama-shi, Kanagawa-ken(JP)

(74) Representative: **Lehn, Werner, Dipl.-Ing. et al**
**Hoffmann, Eitle & Partner Patentanwälte**
**Arabellastrasse 4**
**W-8000 München 81(DE)**

(54) Bi-CMOS integrated circuit.

(57) There is disclosed a Bi-CMOS integrated circuit including an NPN-type (8, 15, 16) bipolar transistor, a P-MOS transistor (9, 17, 20), an N-MOS transistor (11, 18, 21) which are formed on the same substrate, wherein an N-type region (1, 2, 4, 9) is formed so that a P-type isolation region for isolating the NPN-type bipolar transistor and the MOS transistor is electrically isolated from the P-type region for the N-MOS transistor. In such a structure, since different bias potentials can be applied to the P-type isolation region and the P-type region for the N-MOS transistor, respectively, high speed operation can be attained without any erroneous operation.

FIG. 3

## BI-CMOS INTEGRATED CIRCUIT

### BACKGROUND OF THE INVENTION

This invention relates to a Bi-CMOS integrated circuit in which a bipolar transistor and a CMOS transistor are formed on the same substrate.

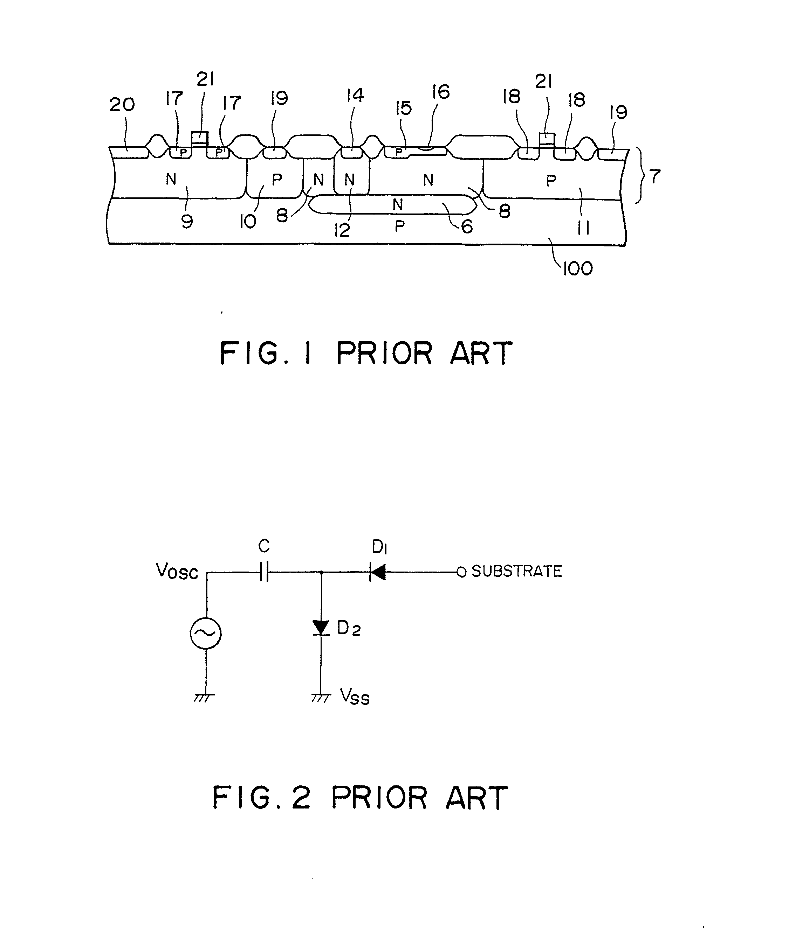

A conventional Bi-CMOS integrated circuit including an NPN-type bipolar transistor and a CMOS transistor formed on the same substrate is shown in FIG. 1. This Bi-CMOS integrated circuit is formed as follows. An N-type buried layer 6 is formed in a predetermined region on the P-type substrate 100. An N-type layer 7 is then formed by epitaxial growth on the entire surface. Subsequently, an N well 8 serving as the collector region of the NPN type transistor is formed in the layer 7 on the N-type buried layer 6, and an N well 9 for a P-channel MOS transistor region, a P well 10 for isolation which isolates these N wells 9 and 8, and a P well 11 for an N-channel MOS transistor region are formed in respective predetermined regions of the layer 7. Thereafter, an N-type layer 12 is formed within the N well 8 so as to reach the buried layer 6. Then, an N-type diffused layer 14 serving as the collector electrode is formed within the N-type layer 12, and a P-type diffused layer 15 serving as the base is formed within the N-channel 8 for the collector region. Subsequently, an N-type diffused layer 16 serving as the emitter is formed by implantation/diffusion process within the P-type diffused layer 15. An NPN transistor is thus formed. Further, polysilicon is used to form a gate 21 within the N well 9 for the P-channel MOS transistor. Subsequently, a P-type diffused layer 17 serving as a drain/source region is formed. A P-MOS transistor is thus completed. Similarly, polysilicon is used to form a gate 21 within the p well 11. Further, an N-type diffused layer 18 serving as a drain/source region is formed. An N-channel MOS transistor is thus formed. A P-type diffused layer 19 for bias is formed in the regions of the P well 11 and the P well 10 for isolation, and an N-type diffused layer 20 for bias is formed in the region of the N well 9. A Bi-CMOS integrated circuit is thus formed. In such an integrated circuit, ordinarily the CMOS transistor section biases the N well region 9 of the P-channel MOS transistor so that it has a power supply level, and biases the P well region 11 of the N-channel MOS transistor so that it has a ground level. In this instance, an approach is employed to biases the P well region 11 of the N-MOS transistor so that it has a level corresponding to an output from the substrate bias circuit comprised of a capacitor C and rectifier elements $D_1$ and $D_2$ as shown in FIG. 2 in place of the ground level. As a result, the junction capacity between the source/drain region and the substrate is reduced by the substrate bias effect. Thus, a high speed N-channel MOS transistor can be realized.

However, in such a Bi-CMOS integrated circuit, since a parasitic PNP-type bipolar transistor is formed by the base region (P-type) 15 and the collector region (N-type) 8 of the NPN-type bipolar transistor and the substrate (P-type) 100, when the NPN type bipolar transistor becomes saturated, the parasitic PNP type bipolar transistor is turned ON, so a current flows in the substrate 100, resulting in a raised substrate potential. For this reason, where the substrate bias is used, influence is exerted also on the P well region 11 of the N-channel MOS transistor electrically connected through the substrate 100, resulting in the problem that the N-channel MOS transistor may erroneously operate.

### SUMMARY OF THE INVENTION

Accordingly, an object of this invention is to provide a Bi-CMOS integrated circuit which can realize a high speed operation of the N-channel MOS transistor.

According to the present invention, there is provided a Bi-CMOS integrated circuit comprising:
an NPN transistor formed on a substrate surface,
a CMOS transistor comprised of a P-channel MOS transistor and an N-channel MOS transistor, formed on said substrate surface, and
an N-type region for isolation for electrically isolating a P-type region for isolation between bipolar/CMOS adjoining a N-type region serving as the collector of said NPN transistor and a P-type region of said P-channel MOS transistor.

In accordance with the Bi-CMOS integrated circuit of this invention, the N-type isolation region is formed in a manner to be electrically isolated from the P-type region for the N-channel MOS transistor. Since there is employed a scheme such that potentials are delivered from bias circuits different from each other to the P-type isolation region and the P-type region, respectively, high speed operation can be attained without causing an erroneous operation.

### BRIEF DESCRIPTION OF THE DRAWINGS

In the accompanying drawings:
FIG. 1 is a cross sectional view showing respective components of a conventional Bi-CMOS integrated circuit;

FIG. 2 is a circuit diagram showing a substrate bias circuit;

FIG. 3 is a cross sectional view showing respective components of a first embodiment of a Bi-CMOS integrated circuit according to this invention;

FIG. 4 is a cross sectional view showing respective components of a second embodiment of a Bi-CMOS integrated circuit according to this invention;

FIG. 5 is a cross sectional view showing respective components of a third embodiment according to this invention in which device isolation is carried out by trench; and

FIG. 6 is a cross sectional view showing respective components of a fourth embodiment according to this invention in which the substrate bias circuit is mixedly included.

## DESCRIPTION OF THE PREFERRED EMBODIMENTS

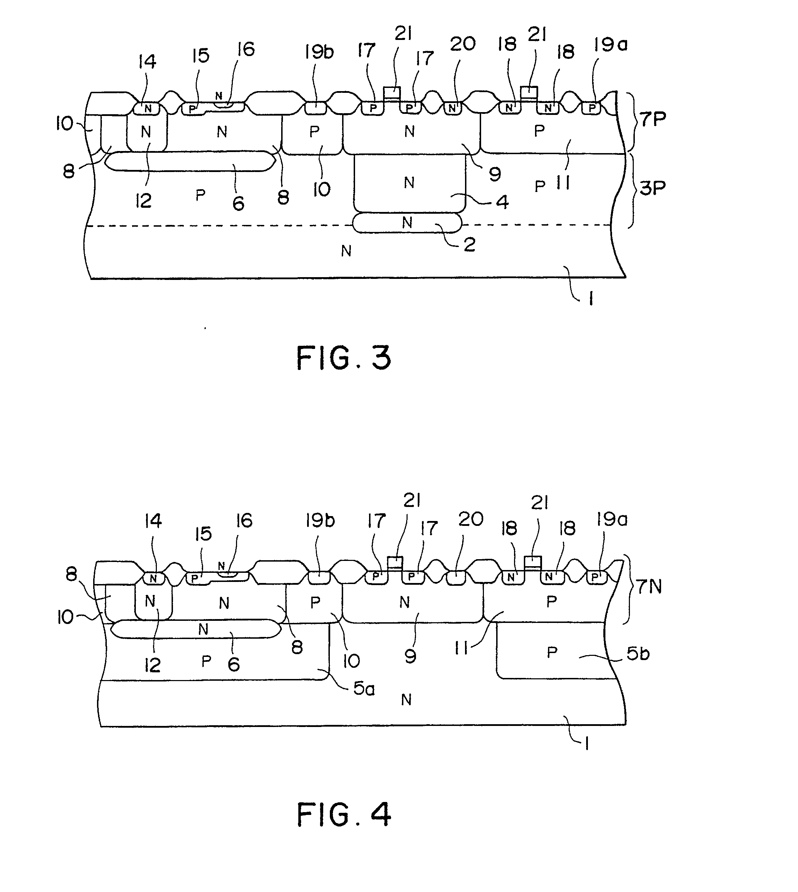

A first embodiment of a Bi-CMOS integrated circuit according to this invention will now be described with reference to FIG. 3. The Bi-CMOS integrated circuit of the first embodiment will be formed as follows.

Initially, an N-type buried layer 2 is formed on an N-type substrate 1. A P-type layer 3 is then formed by epitaxial growth on the entire surface. An N well 4 is formed in the region of the P-type layer 3 on the buried layer 2 so that it is connected to the buried layer 2. Further, an N-type buried layer 6 is formed in the region on the P-type layer 3 where an NPN-type bipolar transistor is formed. Subsequently, a P-type layer 7 is formed by epitaxial growth on the entire surface for a second time. Then, an N well 9 for the P-MOS transistor is formed in the region of the P-type layer 7 on the N well 4 so that it is connected to the N well 4. Further, an N well 8 for the NPN type bipolar transistor is formed in the region of the P-type layer 7 on the buried layer 6 so that it is connected to the buried layer 6. Between the N wells 8 and 9, there is formed an isolation region 10 corresponding to the P-type region or the P well region for separating the P-MOS transistor and the NPN-type bipolar transistor. Thereafter, a P well 11 for the N-MOS transistor is formed in the region of the P-type layer 7 adjoining the N well 9 by a process similar to the process for manufacturing the conventional Bi-CMOS integrated circuit. Then, an N-type layer 12 is formed within the N well 8 so as to reach the buried layer 6. Moreover, an N-type diffused layer 14 serving as the collector electrode is formed within the N-type layer 12, and a P-type diffused layer 15 serving as the base is formed within the N well 8 for the collector region. Further, an N-type layer 16 serving as the emitter is formed by implantation/diffusion process, etc. within the P-type diffused layer 15. An NPN transistor is thus formed. Subsequently, polysilicon is used to form a gate 21 within the N-well 9 for the P-MOS transistor. Further, a P-type diffused layer 17 serving as the drain/source region is formed. A P-MOS transistor is thus completed. Similarly, polysilicon is used to form a gate 21 within the P well 11. Further, an N-type diffused layer 18 serving as the drain/source region is formed to thereby form an N-MOS transistor. Subsequently, P-type diffused layers 19a and 19b for bias are formed within the regions of the P well 11 and the P well 10 for isolation, and an N-type diffused layer 20 for bias is formed within the region of the N well 9. A Bi-CMOS integrated circuit is thus formed.

In the Bi-CMOS integrated circuit thus formed, since the P well 11 for the N-MOS transistor and the P well 10 for isolation are completely electrically isolated from each other by the N well 9 for the P-MOS transistor, the N well 4, the N-type buried layer 2, and the N-type substrate 1, it is possible to bias individually the P well 10 for isolation and the P well 11 for the N-MOS transistor. Thus, by biasing the P well 10 for separation so that it has a ground level, and biasing the P well 11 for the N-MOS transistor so that it has a corresponding to an output from the substrate bias circuit, e.g., as shown in FIG. 2, high speed operation can be attained without causing an erroneous operation. It is to be noted that the N well 9 for the P-MOS transistor is biased so that it has a power supply level.

Further, in the above-described embodiment, the N-type buried layer 2 completely ensures an electrical connection of the N well 4 and the N-type substrate 1. However, if an electrical connection of the N well 4 and the N-type substrate 1 is completely established, the N-type buried layer 2 may be omitted. Furthermore, while the P wells 10 and 11 are formed within the P-type epitaxial layer 7 in the above-described embodiment, it is not necessarily required to form these P wells 10 and 11. In addition, an N-type epitaxial layer 7 may be formed in place of the P-type epitaxial layer 7. At this time, it is not necessarily required to form N wells 8 and 9.

A second embodiment of a Bi-CMOS integrated circuit according to this invention is shown in FIG. 4. The Bi-CMOS integrated circuit of this embodiment is formed as follows. Initially, P wells 5a and 5b for separation are formed in predetermined regions on an N-type substrate 1, respectively. Further, an N-type buried layer 6 is formed in a region where an NPN-type bipolar transistor is formed within the P well 5a for separation. An N-type epitaxial layer 7 is then formed. Subsequently, a process similar to that of the first embodiment is used to form an NPN-type bipolar transistor and a MOS transistor. Thus, a Bi-CMOS integrated circuit is completed.

Also in the Bi-CMOS integrated circuit of the second embodiment thus formed, since the P wells 5a and 10 for separation and P wells 11 and 5b for the N-channel MOS transistor are electrically isolated from each other by the N well 9 for the P-channel MOS transistor and the N-type substrate 1, it is possible to individually bias the P wells 5a and 10 for separation and the P wells 11 and 5b for the N-channel MOS transistor, respectively. Thus, high speed operation can be attained without causing an erroneous operation.

It is to be noted that while P wells 5a and 5b for separation are formed on the N-type substrate 1 in the above-described second embodiment, N wells may be formed at the same time in regions except for the regions where these P wells 5a and 5b are formed. Further, while N wells 8 and 9 are formed within the N-type epitaxial layer 7 in the second embodiment, it is not necessarily required to form N wells 8 and 9. In addition, a P-type epitaxial layer may be formed in place of the N-type epitaxial layer 7. At this time, it is not necessarily required to form P wells 10 and 11.

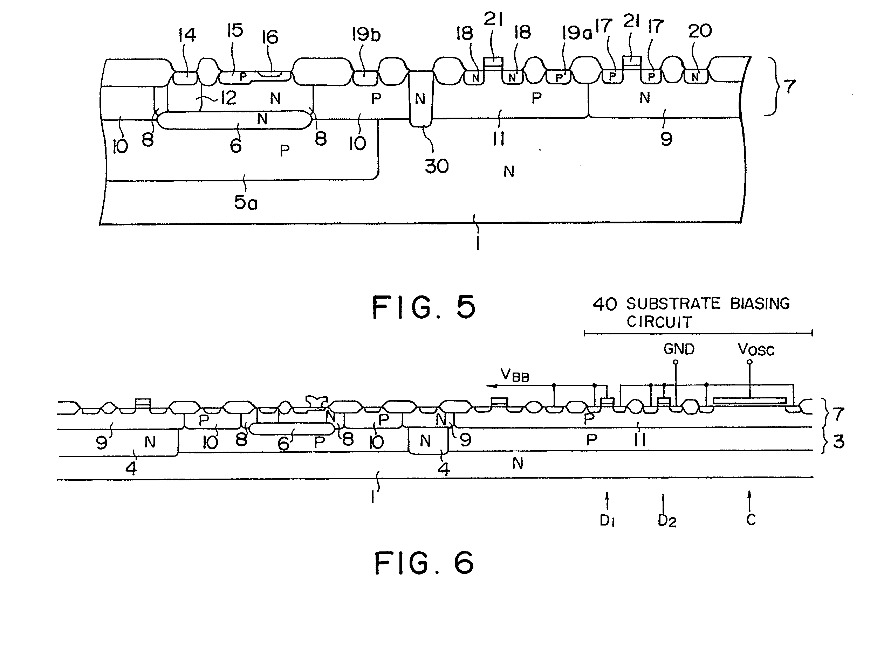

FIG. 5 is a cross sectional view showing respective components of a third embodiment according to this invention, wherein the same or similar reference numerals are attached to portions equivalent or similar to those of the embodiments shown in FIGS. 3 and 4, respectively, and the detailed description will be omitted.

A Bi-CMOS integrated circuit of FIG. 5 has a structure similar to the structure of FIG. 4, wherein a trench-shaped N-type isolation layer 30 is provided in place of the N well 9 for the P-channel transistor. Trenching is carried out by a well known method. The depth of the trench thus formed is set to a value larger than the thickness of the epitaxial layer 7.

Also in the case of this embodiment, since the P wells 5a and 10 for isolation and the P well 11 for the N-channelf MOS transistor are electrically isolated by the trench 30 and the N-type substrate 1, it is possible to individually apply bias voltages thereto, respectively. Thus, high speed operation can be attained while preventing an erroneous operation.

FIG. 6 shows a fourth embodiment of this invention. In addition to the structure shown in FIG. 3, a substrate bias circuit 40 composed of a plurality of transistors are formed on the surface of the epitaxial layer 7.

By forming the substrate bias circuit on the chip in this way, the quantity of draw-out wires to the external can be reduced.

Reference signs in the claims are intended for better understanding and shall not limit the scope.

## Claims

1. A Bi-CMOS integrated circuit comprising:
an NPN transistor (8, 15, 16) formed on a substrate surface, and
a CMOS transistor comprised of a P-channel MOS transistor (9, 17, 20) and an N-channel MOS transistor, (11, 18, 21) formed on said substrate surface, and
characterized in that said circuit further comprises an N-type region (1, 2, 4, 9) for isolation for electrically isolating a P-type region for isolation between bipolar/CMOS adjoining an N-type region serving as the collector of said NPN transistor and a P-type region of said P-channel MOS transistor.

2. A Bi-CMOS integrated circuit as set forth in claim 1, wherein said N-type region for isolation is comprised of an N-type substrate (1) and an N-type region (9) of said P-channel MOS transistor provided on the surface thereof.

3. A Bi-CMOS integrated circuit as set forth in claim 1, wherein said NPN transistor and said CMOS transistor are formed within a P-type epitaxial layer (7) formed on the surface of an N-type substrate, and wherein said N-type region for isolation is comprised of said N-type substrate, an N-type well formed within said p-type epitaxial layer on the surface of said N-type substrate, and an N-type region for said P-channel MOS transistor formed within a P-type epitaxial layer formed thereon.

4. A Bi-CMOS integrated circuit as set forth in claim 3, wherein an N-type buried layer (2) is provided between said N-type substrate and an N well formed within said P-type epitaxial layer on the surface of said N-type substrate.

5. A Bi-CMOS integrated circuit as set forth in claim 1, wherein said N-type region for isolation is composed of an N-type substrate (1) and an N-type trench region (30) formed so that its bottom portion is in contact with said N-type substrate.

6. A Bi-CMOS integrated circuit as set forth in claim 1, wherein different bias voltages are applied to said N-type region serving as said collector of said NPN transistor and said P-type region of said P-channel MOS transistor, respectively.

7. A Bi-CMOS integrated circuit as set forth in claim 6, wherein bias generation means (40) for generating different bias voltages is provided on the same chip.

FIG. 1 PRIOR ART

FIG. 2 PRIOR ART

5

FIG. 3

FIG. 4

FIG. 5

FIG. 6